# EUROPEAN PATENT APPLICATION

(11) **EP 1 995 634 A2**
(43) Date of publication of application: **26.11.2008**
(21) Application number: 08008032.8
(22) Date of filing: 25.04.2008
(51) Int. Cl.: G03F 7/00

(54) **Lithography for fabricating adherent microstructure**

(30) Priority: 24.05.2007 TW 96118599
(71) Applicant: Contrel Technology Co., Ltd., Sinshin Township, Tainan County 744 (TW)
(72) Inventor: Tsai, Yi-Liang, Tainan County 744 (TW); Hsien, Po-Pin, Tainan County 744 (TW)
(74) Representative: Becker Kurig Straus

(57) **Abstract**

A lithography method includes the steps of preparing a substrate (11) and a mold (21), wherein the mold (21) having a plurality of nanometer-scale features (22) each having a predetermined depth; disposing a liquid imprint layer (31) on the substrate (11); pressing the mold (21) on the substrate (11) to enable the imprint layer (31) to become a base material (32) between the mold (21) and the substrate (11) and to enter the nanometer-scale features (22) for a predetermined depth, wherein a plurality of nano-convexities (34) are formed on the base material and the air in each of the features (22) is compressed; solidifying the imprint layer (31) to convert it from liquid into solid; and releasing the mold (21) by pulling the mold (21) upward away from the substrate (11), wherein counterforce is generated by the compressed air in the features (22) to facilitate disengagement of the nano-convexities (34) from the features (22) successfully and finally the base material and the nano convexities (34) jointly become the adherent microstructure (30).

## Description

### BACKGROUND OF THE INVENTION

### 1. Field of the Invention

The present invention relates generally to nanotechnology, and more particularly, to a lithography method for fabricating an adherent microstructure.

### 2. Description of the Related Art

A known nanoadhesive is derived from the toe of the natural gecko, which exploits van der Waals force generated by extremely high-density spatula of its toes for adhesion onto a surface. The known nanoadhesive can be adhered to a surface by means of high-density cilia formed on its surface.

The known research groups that propose several nanoimprint lithography techniques for fabricating the nanoadhesive include Andre K. Geim et al. in U.K. Manchester University, Metin Sitti et al. in U.S. Carnegie Mellom University, Ali Dhinojwala et al. in U.S. Akron University, and Yang Zhao in U.S. Atlas Scientific Company. High polymer is used in the former two research groups, and carbon nanotube is used in the latter two research groups.

Geim's method is characterized in that ten thousands of polyimide hairs are prepared on a polyimide film by electron beam lithography system, sputtering machine, and plasma etching apparatus. Each of the polyimide hairs is a pillar-like structure of 500-nm in diameter and 2-µm in length. The distance between each two polyimide hairs is 1-µm. The experiment concluded that such artificial hair could bear 300g/cm² and would lose adhesion after reused for several times. However, such method is defective because it needs such expensive equipment, like electron beam lithography system, sputtering machine, and plasma etching apparatus, and it fails to do mass production because the production rate is very slow. In addition, the structure of the polyimide hair is made by etching to alter the characteristic thereof and thus cannot be reused.

As for Sitti's method, it prepares millions of synthetic fiber made of silicone rubber by molding. The experiment concluded that such fiber could bear 0.3g/cm². It is defective because the mold cannot be reused, though the molding is capable of rapid mass production is applied, and it fails to meet the requirement for mass production.

Dhinojwala's and Zhao's methods are based on synthetic nanotube as the spatula of the gecko's toe. Although it produces certain adhesion as the gecko's spatula does, it is still defective because the nanotube is too high in the temperature of growth to directly grow on the flexible substrate of high polymer.

### SUMMARY OF THE INVENTION

The primary objective of the present invention is to provide a lithography method for fabricating an adherent microstructure, in which the mold is reusable to meet the commercial requirement for mass production and low cost.

The foregoing objectives of the present invention is attained by the lithography method, which includes the steps of preparing a substrate and a mold, wherein the mold having a plurality of nanometer-scale features each having a predetermined depth; disposing a liquid imprint layer on the substrate; pressing the mold on the substrate to enable the imprint layer to become a base material between the mold and the substrate and to enter the nanometer-scale features for a predetermined depth, wherein a plurality of nano-convexities are formed on the base material and the air in each of the features is compressed; solidifying the imprint layer to convert it from liquid into solid; and releasing the mold by pulling the mold upward away from the substrate, wherein counterforce is generated by the compressed air in the features to facilitate disengagement of the nano-convexities from the features successfully and finally the base material and the nano convexities jointly become the adherent microstructure.

### BRIEF DESCRIPTION OF THE DRAWINGS

FIG. 1 is a schematic view of a first preferred embodiment of the present invention, illustrating a first step.
FIG. 2 is a schematic view of the first preferred embodiment of the present invention, illustrating a second step.
FIG. 3 is a schematic view of the first preferred embodiment of the present invention, illustrating a third step.
FIG. 4 is a schematic view of the first preferred embodiment of the present invention, illustrating a fourth step.
FIG. 5 is a schematic view of the first preferred embodiment of the present invention, illustrating a fifth step.
FIG. 6 is a schematic view of a second preferred embodiment of the present invention, illustrating a first step.
FIG. 7 is a schematic view of the second preferred embodiment of the present invention, illustrating a second step.
FIG. 8 is a schematic view of the second preferred embodiment of the present invention, illustrating a third step.

### DETAILED DESCRIPTION OF PREFERRED EMBODIMENTS

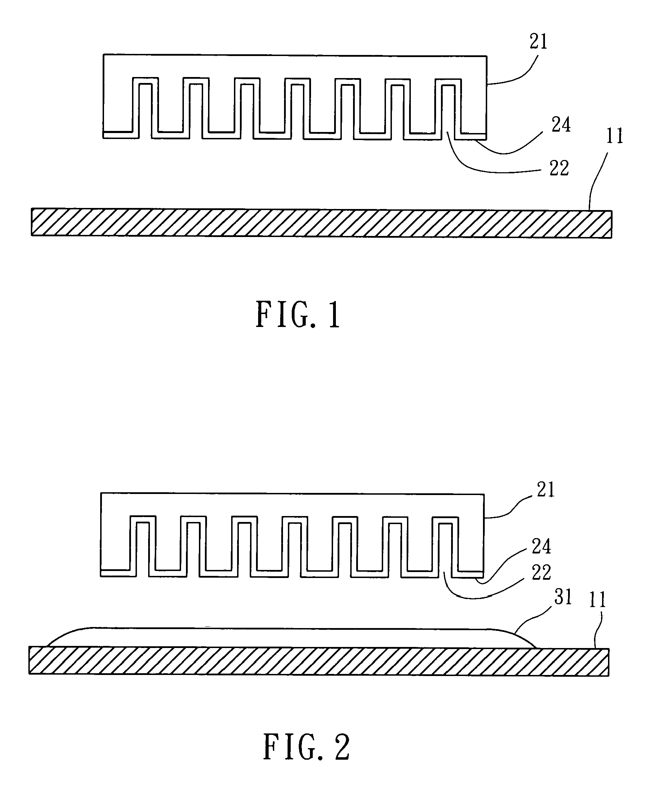

Referring to FIGS. 1-5, a lithography method for fabricating an adherent microstructure 30 in accordance with a first preferred embodiment of the present invention includes the following steps.

### (A) Prepare a substrate 11 and a mold 21.

As shown in FIG. 1, the mold 21 includes a plurality of nanometer-scale features 22 formed on a bottom side thereof. Each of the features 22 has a predetermined depth and is provided with a diameter of 0.01-5µm. A mold release agent 24 is disposed on the bottom side of the mold 21, covering the bottom side of the mold 24 and sidewalls of the features 22. The mold release agent 24 much facilitates a product to disengage from the mold 21 while the mold is being pulled out.

### (B) Dispose a liquid imprint layer 31 on the substrate 11.

As shown in FIG. 2, the imprint layer 31 is one of polymer, compound of polymer and organic nanoparticle, compound of polymer and inorganic nanoparticle, copolymer of polymer and organic nanoparticle, and copolymer of polymer and inorganic nanoparticle.

### (C) Press the mold 21 on the substrate 11.

In this way, the imprint layer 31 is located between the mold 21 and the substrate 11 to become a base material 32, the imprint layer 31 enters the features 22 to form a plurality of nano-convexities 34 on the base material 32, and the air in the features 22 is compressed.

### (D) Solidify the imprint layer 31 to convert it from liquid into solid.

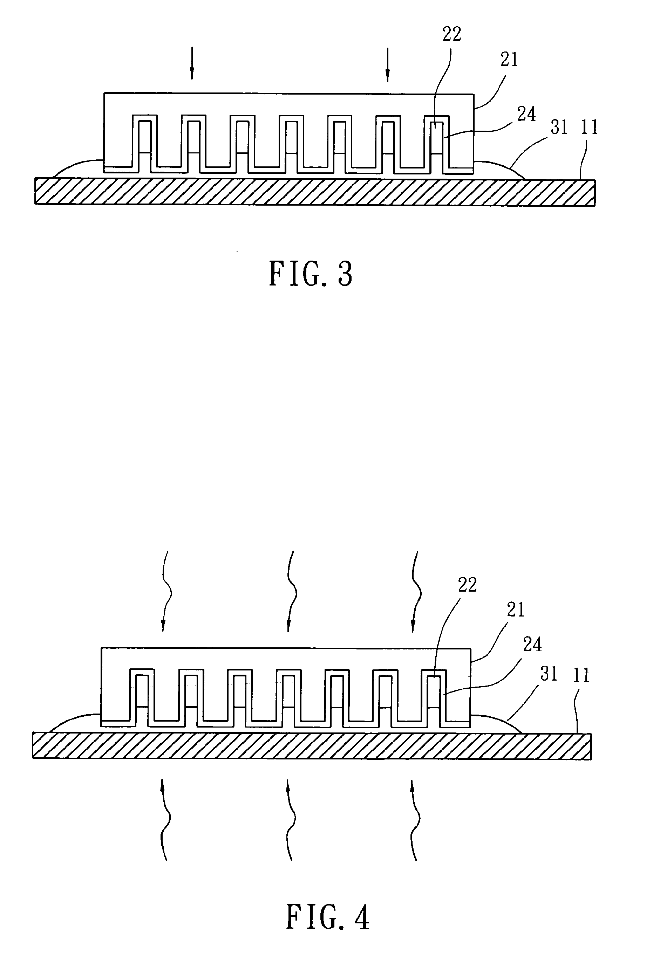

As shown in FIG. 4, the imprint layer 31 is solidified by heating or irradiation of ultraviolet rays, being converted from liquid into solid. In this way, the base material 32 and the nano-convexities 34 are permanently set without change. FIG. 4 shows that the imprint layer 31 is irradiated by ultraviolet rays; under the circumstances, the mold 21 is made of transparent material to facilitate penetration of the ultraviolet rays therethrough. Alternatively, the substrate 11 can be made of transparent material to allow penetration of the ultraviolet rays therethrough.

### (E) Release the mold 21 by pulling the mold 21 upward away from the substrate 11.

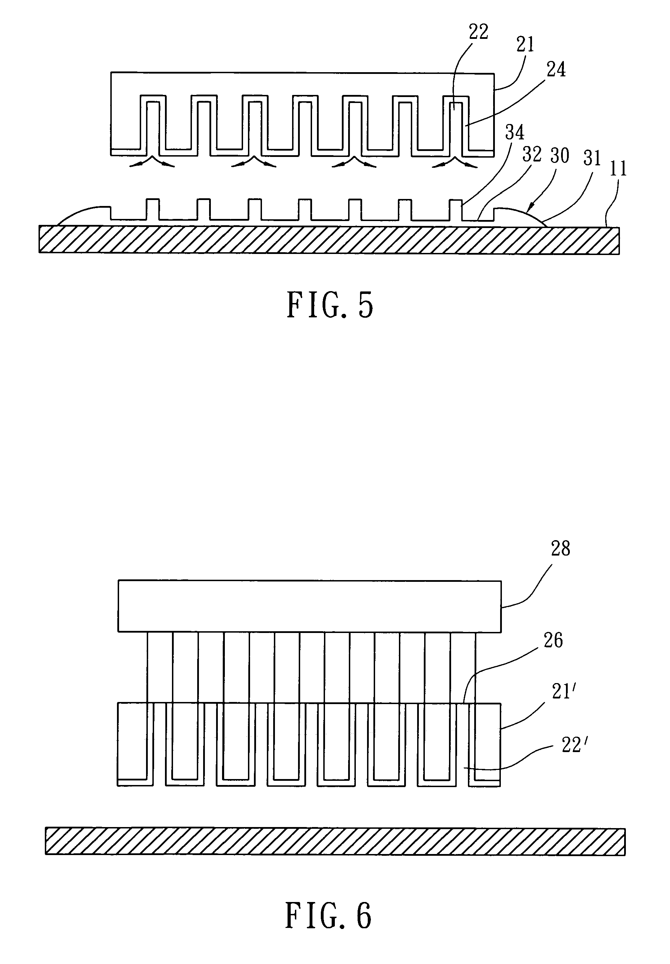

As shown in FIG. 5, the compressed air in the features 22 generates counterforce to facilitate the nano-convexities 34 to disengage from the features 22 successfully. In this way, the base material 32 and the nano-convexities 34 jointly become the adherent microstructure 30. The depth of each of the features 22 is larger than the height of each of the nano-convexities 34 for more than double.

In light of the above, the adherent microstructure 30 is composed of the base material 32 and the nano-convexities 34. Each of the nano-convexities 34 is ranged between 0.01 µm and 5µm in diameter and is smaller than 10µm in height.

Referring to FIGS. 6-8, a lithography method for fabricating an adherent microstructure in accordance with a second preferred embodiment of the present invention is similar to the first embodiment, having the following difference.

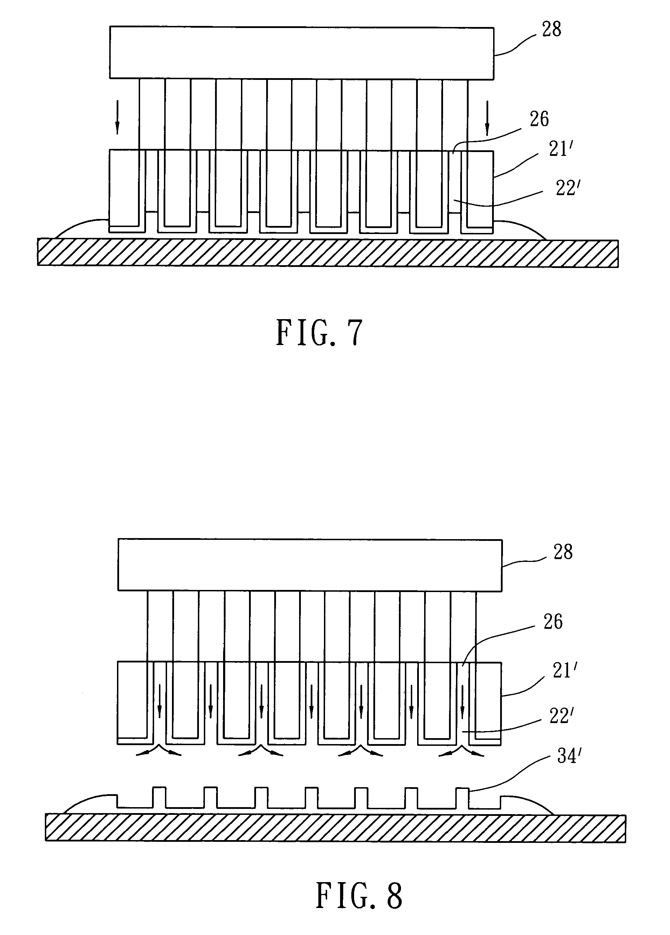

In the step (A), while the mold 21' is being released, as shown in FIG. 8, each of the features 22' of the mold 21' runs through the mold 21' to form an opening 26' and the openings 26' are connected with a gas source 28. In this embodiment, the openings 26 are located at a top side of the mold 21'.

In the step (C), the air in each of the features 22' is in communication with the gas source 28.

In the step (E), while the mold 21' is being released, as shown in FIG. 8, the gas source 28 provides the nano-convexities 22' with the air of predetermined pressure to attain the same effect as the counterforce of the compressed air does in the first embodiment. In other words, the air provided by the gas source 28 can push the nano-convexities 34' out of the features 22' while the mold' is being released.

Because the rest of operations of the second embodiment are the same as that of the first embodiment, no more recitation is necessary.

In conclusion, the lithography method of the present invention quickly produces a large number of nanometer-scale features acted as the adherent microstructure by means of simple molding under the general environment in no need of vacuum, not only meeting the commercial requirement for mass production but also having low-cost advantage, such that the present invention is of more commercial advantages.

Although the present invention has been described with respect to specific preferred embodiments thereof, it is no way limited to the details of the illustrated structures but changes and modifications may be made within the scope of the appended claims.

## Claims

1. A lithography method for fabricating an adherent microstructure (30), being **characterized in that** the lithography method comprises steps of:
(A) preparing a substrate (11) and a mold (21), wherein said mold (21) comprises a plurality of nanometer-scale features (22) on a bottom side thereof, each of said features (22) having predetermined depth;
(B) disposing a liquid imprint layer (31) on said substrate (11);
(C) pressing said mold (21) on said substrate (11), wherein said imprint layer (31) is located between said mold (21) and said substrate (11) to become a base material (32), said imprint layer (31) enters said features (22) to form a plurality of nano-convexities (34) on said base material (32), and the air in said features (22) is compressed;
(D) solidifying said imprint layer (31) to convert it from liquid into solid;
(E) releasing said mold (21) by pulling said mold (21) upward away from said substrate (11), wherein the compressed air in said features (22) generates counterforce to facilitate said nano-convexities (34) to disengage from said features (22) successfully and then said base material (32) and said nano-convexities (34) jointly become said adherent microstructure (30).

2. The lithography method as defined in claim 1 being **characterized in that** the lithography method further comprises a step (F) of unfixing said adherent microstructure (30) from said substrate (11).

3. The lithography method as defined in claim 1 being **characterized in that** said mold (21) at the bottom side thereof in the step (A) is disposed with a mold release agent (24), said mold release agent (24) covering the bottom side of said mold (21) and sidewalls of said features (22).

4. The lithography method as defined in claim 1 being **characterized in that** each of said features (22) has a diameter of 0.01-5µm, and the depth of each of said features (22) is larger than the height of each of said nano-convexities (34) for more than double.

5. The lithography method as defined in claim 1 being **characterized in that** said imprint layer (31) is a polymer.

6. The lithography method as defined in claim 1 being **characterized in that** said imprint layer (31) is a compound of polymer and organic nanoparticle.

7. The lithography method as defined in claim 1 being **characterized in that** said imprint layer (31) is a compound of polymer and inorganic nanoparticle.

8. The lithography method as defined in claim 1 being **characterized in that** said imprint layer (31) is a copolymer of polymer and organic nanoparticle.

9. The lithography method as defined in claim 1 being **characterized in that** said imprint layer (31) is a copolymer of polymer and inorganic nanoparticle.

10. The lithography method as defined in claim 1 being **characterized in that** said imprint layer (31) in the step (D) can be solidified by heating or irradiation of ultraviolet rays, and one of said mold (21) and said substrate (11) is transparent.

11. The lithography method as defined in claim 1 being **characterized in that** each of said features (22) runs through said mold (21) to form an opening (26'), said openings (26') being connected with a gas source (28).

12. An adherent microstructure made by the lithography method defined in claim 1 is **characterized in that** the adherent microstructure (30) is composed of a base material and a plurality of nano-convexities (34) located on said base material (32), wherein each of said nano-convexities (34) has a diameter of 0.01-5µm and a height smaller than 10µm.
